**Europäisches Patentamt**

**European Patent Office**

**Office européen des brevets**

(19)

(11)  **EP 1 276 227 A2**

(12)  **EUROPEAN PATENT APPLICATION**

(43) Date of publication:
    **15.01.2003  Bulletin 2003/03**

(51) Int Cl.⁷: $H03F\ 1/32$

(21) Application number: **02254877.0**

(22) Date of filing: **11.07.2002**

(84) Designated Contracting States:
    **AT BE BG CH CY CZ DE DK EE ES FI FR GB GR
    IE IT LI LU MC NL PT SE SK TR**
    Designated Extension States:
    **AL LT LV MK RO SI**

(30) Priority: **13.07.2001  JP 2001213316
        16.05.2002  JP 2002141184**

(71) Applicant: **Hitachi Kokusai Electric Inc.
    Tokyo 164-8511 (JP)**

(72) Inventors:
    • **Yamakawa, Junichiro, Hitachi Kokusai Elec. Inc.
      Nakano-ku, Tokyo 164-8511 (JP)**
    • **Nanao, Yoshinari, c/o Hitachi Kokusai Elec. Inc.
      Nakano-ku, Tokyo 164-8511 (JP)**

(74) Representative: **Nicholls, Michael John
    J.A. KEMP & CO.
    14, South Square
    Gray's Inn
    London WC1R 5JJ (GB)**

(54)  **Feedforward amplifier**

(57)  A feedforward amplifier is provided that divides a signal to be amplified, amplifies one divided signal with a main amplifier, combines the amplified signal and another divided signal to detect distortion components generated in the main amplifier and contained in the amplified signal, amplifies the detected distortion components with an auxiliary amplifier, and combines the amplified distortion components and the amplified signal from the main amplifier to remove those of the distortion components present in a prescribed band from the amplified signal. The feedforward amplifier includes a filter, typically installed ahead of the auxiliary amplifier, that reduces out-of-prescribed-band components contained in the detected distortion components, thereby improving the characteristic of the out-of-prescribed-band noise.

Fig.1.

EP 1 276 227 A2

**Description**

This invention relates to a feedforward amplifier utilized in the base station of a mobile phone system, the PHS (Personal Hand phone System) or other such mobile telecommunications system to detect distortion components generated in the main amplifier for amplifying the transmit signal and remove from the amplified signal those of the distortion components present in a prescribed band, and particularly to a feedforward amplifier that reduces noise outside the prescribed band.

The well-known feedforward amplifier (FF amplifier) is the one generally used in the base stations of a mobile telecommunications system or the like as the common amplifier for amplifying multichannel RF signals including multiple frequency components. In recent years, the implementation of various types of mobile telecommunications systems has called attention particularly to the problem experienced by systems that use nearby frequencies for wireless telecommunications of noise contained in the telecommunications signals of one system causing interference in another system. A case in point is, for example, the problem currently under study of noise contained in W-CDMA (Wide band - Code Division Multiple Access) system telecommunications signals causing interference in the PHS telecommunications band.

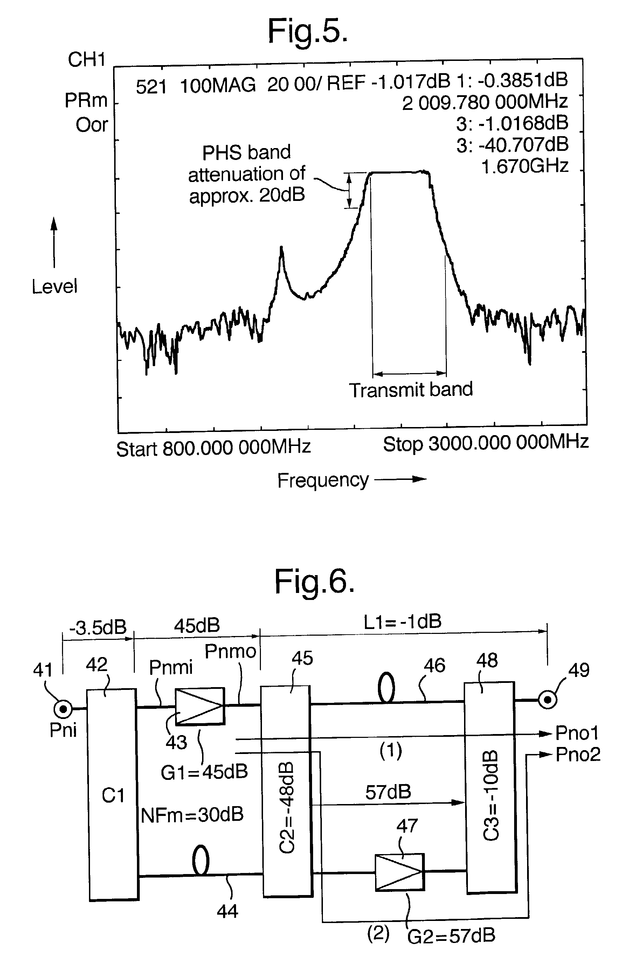

FIG. 6 shows an example of a feedforward amplifier installed in the transmitter unit, for instance, of a base station provided in a mobile telecommunications system utilizing the W-CDMA technology and used to amplify signals for wireless transmission from the base station.

What the illustrated feedforward amplifier does, in most general terms, is to use the feedforward technique to compensate for the distortion components generated in a main amplifier 43 when the main amplifier 43 amplifies a transmit signal.

Specifically, the signal to be transmitted (transmit signal) is input to an input terminal 41, the input transmit signal is divided by a first directional coupler 42, one divided signal is multiplied by the amplifier 43 (sometimes called the main amplifier herein), and the other divided signal is delayed by a first delay line 44.

The amplified signal output by the main amplifier 43 (the transmit signal) and the other divided signal delayed by the first delay line 44 are combined by a second directional coupler 45 to detect (extract) the distortion components generated in the main amplifier 43 and contained in the amplified signal, the detected distortion components are amplified by an amplifier 47 (sometimes called the auxiliary amplifier herein), and the amplified signal output by the main amplifier 43 is delayed by a second delay line 46. In this process, the second directional coupler 45 combines part of the amplified signal received from the main amplifier 43 and the other divided signal received from the first delay line 44 and outputs the remaining part of the amplified signal to the second delay line 46.

The amplified distortion components output by the auxiliary amplifier 47 and the amplified signal delayed by the second delay line 46 are combined by a third directional coupler 48 to remove from the amplified signal those of the distortion components present in a prescribed band. The amplified signal removed of the distortion components present in the prescribed band is output from an output terminal 49. The band defined as the prescribed band is, for example, one including the transmit band and having several times the width of the transmit band. A concrete example of the prescribed band would be, for example, a band centered on the transmit band and extending to the same width on either side of the transmit band so as to have an overall width that is a number of times that of the transmit band.

Thus when the main amplifier 43 amplifies and outputs a transmit signal that fits within the transmit band, the foregoing operation of the illustrated feedforward amplifier enables output of an amplified signal removed of those of the distortion components generated in the main amplifier 43 that are present in the prescribed band.

The time that the first delay line 44 delays the other divided signal can be defined as a time that enables the second directional coupler 45 to combine the amplified signal from the main amplifier 43 and the other divided signal from the first delay line 44 in opposite phase (i.e., with a difference of 180 degrees between their phases) and thereby suitably detect the distortion components generated in the main amplifier 43.

Similarly, the time that the second delay line 46 delays the amplified signal from the main amplifier 43 can be defined as a time that enables the third directional coupler 48 to combine the amplified signal from the second delay line 46 and those of the distortion components present in the prescribed band from the auxiliary amplifier 47 so as to realize suitable removal of the those distortion components from the amplified signal.

Even in the same transmission line or processing circuit, the amount of phase shift and the like occurring in a signal generally differs with difference in signal frequency. The illustrated feedforward amplifier is therefore unable to conduct distortion component removal at the same accuracy in every band and can achieve practically effective distortion component removal only with respect to certain bands (e.g., a band that is several times the pass band). Because of this, the pass band of the illustrated feedforward amplifier is set to the transmit band of the wireless signals used by the system in which the feedforward amplifier is utilized. In other words, it is set so as to conduct practically effective distortion component removal in a band that is several times the transmit band. When it is set in this way, the aforesaid feedforward distortion compensation processing removes the distortion components in the transmit band and adjacent bands so that these distortion components are not output from the output terminal 49. However, the distortion components the main amplifier 43 generates in other bands are not removed and are output from the output terminal 49 to become out-of-transmit-band noise.

Next, a specific example will be given of the power of the out-of-band noise output by the illustrated feedforward amplifier (out-of-transmit-band noise removed of components in the prescribed band in which distortion compensation is conducted).

For simplicity of explanation, assume the frequency characteristics of the directional couplers 42, 45 and 48 and the auxiliary amplifier 47 to be the same inside and outside the transmit band and the same inside and outside the prescribed band.

Further assume that the main amplifier 43 has gain G1 = 45 dB, the auxiliary amplifier 47 has gain G2 = 57 dB, the second directional coupler 45 has coupling degree C2 = - 48 dB, the third directional coupler 48 has coupling degree C3 = - 10 dB, the amplified signal from the main amplifier 43 incurs loss L1 = - 1 dB while passing through the second directional coupler 45, second delay line 46 and third directional coupler 48 to the output terminal 49, and the transmit signal incurs loss= - 3.5 dB between input to the input terminal 41 and output from the first directional coupler 42. Also assume no particular limit on the coupling and other conditions like the coupling degree C1 of the first directional coupler 42 and the like.

Assume additionally that the noise index NFm of the main amplifier 43 is equal to the noise index NF from the input terminal 41 and NFm = NF = 30 dB, that the noise band B = 300 kHz $\approx$ 55 dB, and that kT = - 174 dBm/Hz.

Now make an approximate calculation of the power of the out-of-prescribed-band noise under the assumed conditions for a first path (1) of the noise generated in the main amplifier 43 (noise composed of distortion components generated in the main amplifier 43) passing through the second directional coupler 45, second delay line 46 and third directional coupler 48 to the output terminal 49 and a second path (2) of the noise generated in the main amplifier 43 passing through the second directional coupler 45, auxiliary amplifier 47 and third directional coupler 48 to the output terminal 49.

The power Pnmo of the noise generated in the main amplifier 43 (distortion component noise) is represented by Equation 1.

$$Pnmo = kT + B + NF + G1 = - 174 + 55 + 30 + 45 = - 44 \text{ [dBm]} \qquad \text{(Eq. 1)}$$

The power Pno1 of the noise output from the output terminal 49 via the first path (1) is represented by Equation 2 and the power Pno2 of the noise output from the output terminal 49 via the second path (2) is represented by Equation 3.

$$Pno1 = Pnmo + L1 = - 44 - 1 = - 45 \text{ [dBm]} \qquad \text{(Eq. 2)}$$

$$Pno2 = Pnmo + C2 + G2 + C3 = - 44 - 48 + 57 - 10 = - 45 \text{ [dBm]} \qquad \text{(Eq. 3)}$$

The power Pno of the out-of-prescribed-band noise output from the output terminal 49 of the feedforward amplifier is therefore represented by Equation 4.

$$Pno = Pno1 + Pno2 = - 45 \text{ [dBm]} - 45 \text{ [dBm]} = - 42 \text{ [dBm]} \qquad \text{(Eq. 4)}$$

In light of the out-of-prescribed-band noise Pno in this example, and taking into account that the limit established for spurious emissions from the W-CDMA systems that are expected to emerge shortly to the PHS band has been set at -41 dBm/300 kHz, consideration needs to be given to measures for reducing out-of-prescribed-band noise. Although out-of-prescribed-band noise has not been viewed as a serious problem with regard to conventional PDC (Japanese digital cellular mobile telecommunications) devices, it can be expected to emerge as a major issue because the specified output point in W-CDMA is the amplifier (AMP) output and noise standards have been established for the PHS band, receive band and the like.

As pointed out in the foregoing, the conventional feedforward amplifier requires improvement with regard to out-of-prescribed-band noise (out-of-transmit-band noise removed of components in the prescribed band in which distortion compensation is conducted) and a need is felt for development of a feedforward amplifier capable of efficiently reducing out-of-prescribed-band noise.

While out-of-prescribed-band noise could conceivably be diminished by installing a filter at the output terminal 49 to reduce noise in bands that require improvement, this would not be efficient because the increased loss on the output side would result in higher power consumption and also because a large-sized filter would have to be utilized owing to the high level of the noise passing through it.

The present invention was accomplished in light of these circumstances of the prior art, and has as an object to provide a feedforward amplifier that, in the process of detecting distortion components generated in a main amplifier for amplifying signals and removing from the amplified signal those of the distortion components contained in a prescribed band, can reduce out-of-prescribed-band noise.

The present invention achieves these objects by providing a feedforward amplifier that divides a signal to be amplified, amplifies one divided signal with a main amplifier, combines the amplified signal and another divided signal to detect distortion components generated in the main amplifier and contained in the amplified signal, amplifies the detected distortion components with an auxiliary amplifier, and combines the amplified distortion components and the amplified signal from the main amplifier to remove those of the distortion components present in a prescribed band from the amplified signal, which feedforward amplifier comprises a filter that reduces out-of-prescribed-band components contained in the detected distortion components.

Since the feedforward amplifier comprises the filter for reducing out-of-prescribed-band components contained in the detected distortion component a relatively small filter can be used because the level (power) of the distortion components is lower than the level at the output terminal. As the configuration has substantially no effect on power consumption, moreover, the out-of-prescribed-band noise contained in the amplified signal can be reduced with good efficiency to improve the out-of-prescribed-band noise characteristic in comparison with the prior art.

The filter can be installed at any of various locations on the line having the auxiliary amplifier. For example, in the configurations of the embodiments set out later, the filter can be installed at any of various locations on the auxiliary amplifier path between the second directional coupler and the third directional coupler.

The prescribed band can be any of various bands.

When the signal to be amplified is a transmit signal, for example, the prescribed band is preferably a band that is several times the transmit band. Specifically, it is preferably a band centered on the transmit band and extending to the same width on the left and right sides of the transmit band so as to have an overall width (combined width of the left band, transmit band and right band) that is a number of times that of the transmit band. In this case, a transmit band signal is input to the feedforward amplifier and signal of a prescribed band (e.g., band that is several times the transmit band) is output as the signal amplified by the feedforward amplifier.

The transmit band can be any of various bands. In the case of a W-CDMA system, for example, the transmit band can be the 2.11 GHz- 2. 13 GHz band or other band used for transmit signals.

The band having several times the width of the transmit band can be of any of various sizes. It can, for example, be a band that is two or three times the width of the transmit band and, in the case of a W-CDMA system, can be a band on the order of 60 MHz, for instance.

The main amplifier can be any of various types. For example, it can be a single amplifier or a combination of multiple amplifiers.

Similarly, the auxiliary amplifier can be any of various types.

Any of various types of filters can be used. The filter can, for example, be a band-pass filter or a band-elimination filter.

By the statement that the amplified signal is removed of those distortion components among the distortion components generated in the main amplifier that are present in a prescribed band is meant that, as was explained earlier with reference to the prior art, the frequency dependence of distortion compensation accuracy by the feedforward method makes it possible to compensate for and reduce distortion components within a prescribed band with relatively good accuracy but prevents distortion-compensation with respect to out-of-prescribed band distortion components, which therefore markedly remain in the amplified signal. It should be noted, however, that distortion compensation accuracy does not change abruptly at the boundary between inside and outside of the prescribed band and it is therefore possible to adopt a configuration that, in the vicinity of the boundary, enables distortion compensation with some degree of accuracy even outside the prescribed band.

The accuracy with which those of the distortion components present in the prescribed band are removed from the amplified signal can be set as desired in accordance with the conditions of use of the feedforward amplifier.

The filter used to reduce components outside the prescribed band need not necessarily be one that reduces all frequency components outside the prescribed band. It suffices to use a filter that can reduce those frequency components that need to be reduced. The degree of reduction of out-of-prescribed-band distortion components by the filter can be variously set. For example, it suffices for the out-of-prescribed-band distortion components to be reduced to a degree that enables practically effective diminution of out-of-prescribed-band noise.

In one configuration of the feedforward amplifier according to the present invention, the filter is installed ahead of the auxiliary amplifier.

The configuration in which the filter is installed ahead of the auxiliary amplifier is not limited to one in which the filter is installed immediately ahead of the auxiliary amplifier. When one or more other circuits are installed between a distortion component detection means (e.g., the second directional coupler 5, 15 in the embodiments set out later) and the auxiliary amplifier (e.g., the auxiliary amplifier 8, 18 in the embodiments set out later), the filter can be installed at any of various locations between the detection means and the auxiliary amplifier.

In the configurations of the embodiments set out later, for example, a first vector adjuster for adjusting signal phase and amplitude can be provided between a first directional coupler 2, 12 and a main amplifier 3, 13, and a second vector adjuster for adusting distortion component phase and amplitude can be provided between the second directional coupler 5, 15 and an auxiliary amplifier 8, 18. In such a case, the filter can be incorporated between the second vector adjuster and the auxiliary amplifier 8, 18 or between the second directional coupler 5, 15 and the second vector adjuster.

Although the filter is preferably located ahead of the auxiliary amplifier because the filter can be prevented from attenuating of the distortion components amplified by the auxiliary amplifier, the filter can also be installed intermediate of or behind the auxiliary amplifier.

In another configuration of the feedforward amplifier according to this invention, the auxiliary amplifier is constituted by combining multiple amplifier elements and the filter is provided intermediate of the multiple amplifier elements constituting the auxiliary amplifier.

The auxiliary amplifier can have any of various configurations. For example, the multiple amplifier elements constituting the auxiliary amplifier can be combined in various numbers and various modes of combination.

In another configuration of the feedforward amplifier according to the present invention, the filter is installed behind of the auxiliary amplifier.

The configuration in which the filter is installed behind the auxiliary amplifier is not limited to one in which the filter is installed immediately behind the auxiliary amplifier and installation at any of various locations behind the auxiliary amplifier is acceptable.

In a preferred configuration of the feedforward amplifier according to the present invention, a filter is provided for reducing the out-of-prescribed-band components contained in an amplified signal from the main amplifier combined with the amplified distortion components (second filter).

As a result, out-of-prescribed-band noise remaining in the amplified signal after distortion removal can be diminished still further.

The second filter can be installed at any of various locations. In the embodiments set out later, for example, it can be installed at various locations of the path between the second directional coupler that transmits the amplified signal from the main amplifier and the third directional coupler.

The second filter can be any of various types: For example, when the amplified signal from the main amplifier needs to be delayed, it is preferably a delay filter having both delay and filtering capability.

Five specific configurations of the feedforward amplifier according to the present invention are set out below.

(1)

A feedforward amplifier which comprises:

a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and

a distortion removal loop including second delay means that delays the amplified signal from the main amplifier, an auxiliary amplifier that amplifies the distortion components detected by the second directional coupler, a third directional coupler that combines amplified distortion components from the auxiliary amplifier and the amplified signal delayed by the second delay means to remove those of the distortion components present in a prescribed band from the amplified signal, and a filter that reduces out-of-prescribed-band components contained in the distortion components detected by the second directional coupler.

The first delay means and second delay means can be any of various means and can, for example, be delay lines.

The distortion detection loop and distortion removal loop can have any of various configurations. For example, they can be equipped with vector adjusters that adjust signal phase and amplitude for adjusting distortion detection and distortion removal, can be equipped with a processing unit that conducts pilot signal processing for adjusting distortion detection and distortion removal, and can be equipped with a processing unit that conducts feedback processing for enhancing the accuracy of distortion detection and distortion removal.

(2) A feedforward amplifier which comprises:

a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and

a distortion removal loop including second delay means that delays the amplified signal from the main amplifier, a filter that reduces out-of-prescribed-band components contained in the distortion components detected by the second directional coupler, an auxiliary amplifier that amplifies the distortion components from the filter, and a third directional coupler that combines amplified distortion components from the auxiliary amplifier and the amplified signal delayed by the second delay means to remove those of the distortion components present in a prescribed band from the amplified signal.

(3) A feedforward amplifier which comprises:

a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and

a distortion removal loop including second delay means that delays the amplified signal from the main amplifier, an auxiliary amplifier constituted by combining multiple amplifier elements that amplifies the distortion components detected by the second directional coupler, a filter provided intermediate of the multiple amplifier elements constituting the auxiliary amplifier that reduces out-of-prescribed-band components contained in the distortion components detected by the second directional coupler, and a third directional coupler that combines amplified distortion components from the auxiliary amplifier and the amplified signal delayed by the second delay means to remove those of the distortion components present in a prescribed band from the amplified signal.

(4) A feedforward amplifier which comprises:

a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and

a distortion removal loop including second delay means that delays the amplified signal from the main amplifier, an auxiliary amplifier that amplifies the distortion components detected by the second directional coupler, a filter that reduces out-of-prescribed-band components contained in the amplified distortion components from the auxiliary amplifier, and a third directional coupler that combines amplified distortion components from the filter and the amplified signal delayed by the second delay means to remove those of the distortion components present in a prescribed band from the amplified signal.

(5) A feedforward amplifier according to any of (1) to (4) above, wherein the second delay means is a filter that reduces the out-of-prescribed-band components contained in the amplified signal from the main amplifier.

The filter can be a delay filter.

The feedforward amplifier according to the present invention can suitably be applied in a base station of a W-CDMA system and used to amplify multichannel RF signals that are the W-CDMA transmit signals. However, it can also be applied to systems that adopt a telecommunications technology other than W-CDMA. Moreover, the feedforward amplifier of the present invention is not limited to application in a base station and can also be incorporated in any of various other telecommunications devices such as a relay (amplifier) station. The filter that is a constituent of the present invention is not limited to one for reducing PHS band components among the distortion components but can be one that reduces components in any prescribed band desired outside the transmit band.

The effect of enabling efficient reduction of out-of-prescribed-band components realized by providing the filter that reduces the out-of-prescribed-band components among the distortion components ahead of, intermediate of or behind the auxiliary amplifier can be obtained not only in the processing of transmit signals but can also be obtained in the processing of any of various other desired signals. In other words, the feedforward amplifier divides the signal to be amplified, amplifies one divided signal with a main amplifier, combines the amplified signal and another divided signal to detect distortion components generated in the main amplifier and contained in the amplified signal, amplifies the detected distortion components with an auxiliary amplifier, and combines the amplified distortion components and the amplified signal from the main amplifier to remove those of the distortion components present in a prescribed band from the amplified signal, and in this process the feedforward amplifier reduces out-of-prescribed-band components contained in the detected distortion components with a filter provided ahead, intermediate or behind the auxiliary amplifier.

The invention will be further described by way of example with reference to the accompanying drawings, in which:-

Figure 1 is a diagram showing the configuration of a feedforward amplifier that is a first embodiment of the present invention;

Figure 2 is a diagram showing the configuration of a feedforward amplifier that is a second embodiment of the present invention;

Figure 3 is a diagram showing the configuration of a feedforward amplifier that is a third embodiment of the present invention

Figure 4 is a diagram showing the configuration of a feedforward amplifier that is a fourth embodiment of the present invention;

Figure 5 is a graph showing an example of a delay filter transmission characteristic; and

Figure 6 is a diagram showing the configuration of a conventional feedforward amplifier.

A feedforward amplifier that is a first embodiment of the present invention will now be explained with reference to the drawings.

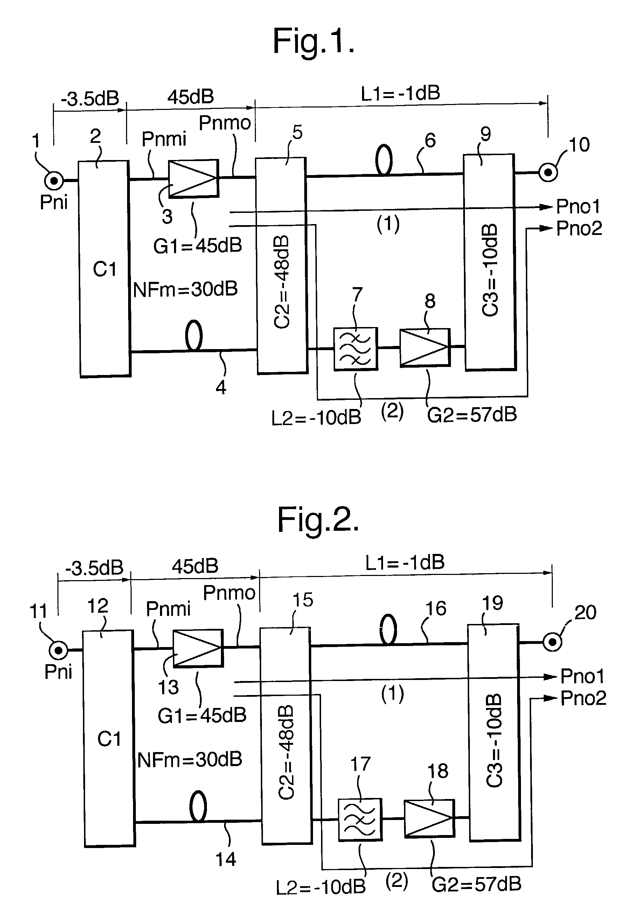

Figure 1 shows the configuration of the feedforward amplifier. This illustrated feedforward amplifier is what is obtained by applying the present invention to the feedforward amplifier shown in Figure 6.

The feedforward amplifier of this embodiment is provided between an input terminal 1 and an output terminal 10 with a first directional coupler 2, a main amplifier 3, a first delay line 4, a second directional coupler 5, a second delay line 6, a band-pass filter 7, an auxiliary amplifier 8, and a third directional coupler 9.

Aside from the provision of the band-pass filter 7 between the second directional coupler 5 and the auxiliary amplifier 8, the feedforward amplifier of this embodiment is similar in configuration and operation to the feedforward amplifier shown in Figure 6. The detailed explanation that follows will therefore focus on the points in which the feedforward amplifier differs in structure and operation from that shown in Figure 6.

In this embodiment, the distortion components detected by the second directional coupler 5 are output to the band-pass filter 7, passed through the band-pass filter 7 and forwarded to the auxiliary amplifier 8.

The band-pass filter 7 passes mainly those of the distortion components received from the second directional coupler 5 that are present in a prescribed band and reduces components outside the prescribed band. Owing to this characteristic of the band-pass filter 7, the amount (power) of components outside the prescribed band passing through the band-pass filter 7 is small. Thus, in this embodiment, the band in which signals are passed by the band-pass filter 7 (the filter pass band) is, for example, set to be the same as the prescribed band. In this embodiment, a band including the transmit band and having a width of several times the transmit band is used as the prescribed band. More specifically, the prescribed band in this embodiment is a band centered on the transmit band and extending to the same width on either side of the transmit band so as to have an overall width that is a number of times that of the transmit band.

A specific example of the power of the out-of-prescribed-band noise (out-of-transmit-band noise removed of components in the prescribed band in which distortion compensation is conducted) output by the feedforward amplifier of this embodiment will now be explained.

As in the earlier description of the feedforward amplifier shown in Figure 6, the explanation of the feedforward amplifier will for simplicity be made on the assumption that the frequency characteristics of the directional couplers 2, 5 and 9 and the auxiliary amplifier 8 are the same inside and outside the transmit band and the same inside and outside the prescribed band.

Also similarly to what was indicated regarding the feedforward amplifier shown in Figure 6, it will be assumed that the main amplifier 3 has gain $G1 = 45$ dB, the auxiliary amplifier 8 has gain $G2 = 57$ dB, the second directional coupler 5 has coupling degree $C2 = -48$ dB, the third directional coupler 9 has coupling degree $C3 = -10$ dB, the amplified signal from the main amplifier 3 incurs loss $L1 = -1$ dB while passing through the second directional coupler 5, second delay line 6 and third directional coupler 9 to the output terminal 10, and the transmit signal incurs loss = - 3.5 dB between input to the input terminal 1 and output from the first directional coupler 2. It is also assumed that there is no particular limit on the coupling and other conditions like the coupling degree C1 of the directional coupler 2 and the like.

Also as in the explanation of the feedforward amplifier shown in Figure 6, assume that the noise index NFm of the main amplifier 3 is equal to the noise index NF from the input terminal 1 and NFm = NF = 30 dB, that noise band B = 300 kHz ≈ 55 dB, and that kT = - 174 dBm/Hz.

Now make an approximate calculation of the power of the out-of-prescribed-band noise under the assumed conditions for a first path (1) of the noise generated in the main amplifier 3 (noise composed of distortion components generated in the main amplifier 3) passing through the second directional coupler 5, second delay line 6 and third directional coupler 9 to the output terminal 10 and a second path (2) of the noise generated in the main amplifier 3 passing through the second directional coupler 5, band-pass filter 7, auxiliary amplifier 8 and third directional coupler 9 to the output terminal 10.

The power Pnmo of the noise generated in the main amplifier 3 (distortion component noise) is represented by Equation 1 set out with regard to the prior art, i.e., Pnmo = - 44 [dBm].

The power Pno1 of the noise output from the output terminal 10 via the first path (1) is represented by Equation 2 set out with regard to the prior art, i.e., Pno1 = -45[dBm].

The power Pno2 of the noise output from the output terminal 10 via the second path (2) is represented by Equation 5.

$$Pno2 = Pnmo + C2 + L2 + G2 + C3 =$$

$$- 44 - 48 - 10 + 57 - 10 = - 55 \text{ [dBm]} \qquad \text{(Eq. 5)}$$

From Equations 2 and 5, it follows that power -Pno of the out-of-prescribed-band noise output from the output terminal 10 of the feedforward amplifier is represented by Equation 6.

$$Pno = Pno1 + Pno2 = - 45 \text{ [dBm]} - 55 \text{ [dBm]} = - 44.6 \text{ [dBm]} \qquad \text{(Eq. 6)}$$

Thus in this example, the out-of-prescribed-band noise contained in the distortion components before amplification by the auxiliary amplifier 8 is diminished 10 dB by the band-pass filter 7 to achieve a 2.6 (=- 42 - (- 44.6)) dB reduction of out-of-prescribed-band noise contained in the signal output from the output terminal 10 relative to the value indicated by Equation 4 in the prior art example. Moreover, since the level (power) of the distortion component ahead of the auxiliary amplifier 8 is relatively low, a relatively small filter can be used as the band-pass filter 7 and the provision of the band-pass filter 7 causes substantially no change in power consumption relative to that of the conventional feedforward amplifier.

Thus, in the process of amplifying the transmit signal with the main amplifier 3 and outputting a signal obtained by using feedforward distortion compensation to remove from the amplified signal those of the distortion components generated in the main amplifier 3 that are present in the prescribed band, the feedforward amplifier of this embodiment removes out-of-prescribed-band components among the distortion components at a point upstream of the auxiliary amplifier 8. As a result, the out-of-prescribed-band noise contained in the amplified signal output from the output terminal 10 can be efficiently reduced and out-of-prescribed-band noise (e.g., noise in a band subject to a strict noise limit) can be diminished more than possible heretofore.

In the feedforward amplifier of this embodiment, the transmit signals are signals wirelessly transmitted from a W-CDMA system base station to mobile stations or the like, PHS band noise components present outside the W-CDMA transmit band (and outside the prescribed band) are reduced by the band-pass filter 7, and, as a result, amplified signals with reduced out-of-prescribed-band noise can be wirelessly transmitted from the base station. Thus when the feedforward amplifier of the present embodiment is installed in the transmitter unit or the like of a W-CDMA system base station or the like, and transmit signals are amplified by the feedforward amplifier, the effect of interference on the bands of other systems such as the PHS system can be efficiently suppressed.

In this embodiment, the function of the first directional coupler 2 constitutes the invention means for dividing a transmit signal, the main amplifier 3 corresponds to the main amplifier for amplifying one divided signal, the function of the second directional coupler 5 constitutes the means for combining the amplified signal and the other divided signal to detect distortion components generated in the main amplifier and contained in the amplified signal, the auxiliary amplifier 8 corresponds to the auxiliary amplifier for amplifying the detected distortion components, and the function of the third directional coupler 9 constitutes the means for combining the amplified distortion components and the amplified signal from the main amplifier to remove those of the distortion components present in a prescribed band from the amplified signal.

Further, in this embodiment, the function of the band-pass filter 7 constitutes the invention filter for reducing the out-of-prescribed-band components among the detected distortion components and the band-pass filter 7 is provided immediately ahead of the auxiliary amplifier 8.

A feedforward amplifier that is a second embodiment of the present invention will now be explained with reference to the drawings.

Figure 2 shows the configuration of the feedforward amplifier. This feedforward amplifier is what is obtained by applying the present invention to the feedforward amplifier shown in Figure 6.

The feedforward amplifier of this embodiment is provided between an input terminal 11 and an output terminal 20 with a first directional coupler 12, a main amplifier 13, a first delay line 14, a second directional coupler 15, a second delay line 16, a band-elimination filter 17, an auxiliary amplifier 18, and a third and directional coupler 9.

Aside from the provision of the band-elimination filter 17 between the second directional coupler 15 and the auxiliary amplifier 18, the feedforward amplifier of this embodiment is similar in configuration and operation to the feedforward amplifier shown in Figure 6. The configuration of the feedforward amplifier is what is obtained by replacing the band-pass filter 7 provided in the feedforward amplifier of the first embodiment shown in Figure 1 with the band-elimination filter 17.

In this embodiment, the distortion components detected by the second directional coupler 15 are output to the band-elimination filter 17, passed through the band-elimination filter 17 and forwarded to the auxiliary amplifier 18.

The band-elimination filter 17 reduces out-of-prescribed-band components among the distortion components received from the second directional coupler 15 and passes mainly components present in a prescribed band. Thus, in this embodiment, as in the first embodiment, a band including the transmit band and having a width of several times the transmit band is used as the prescribed band. More specifically, the prescribed band in this embodiment is a band centered on the transmit band and extending to the same width on either side of the transmit band so as to have an overall width that is a number of times that of the transmit band.

Thus, similarly to the feedforward amplifier of the first embodiment, the feedforward amplifier of this second embodiment. removes out-of-prescribed-band components among the distortion components at a point upstream of the auxiliary amplifier 18. As a result, the out-of-prescribed-band noise contained in the amplified signal output from the output terminal 20 can be efficiently reduced and out-of-prescribed-band noise can be diminished more than possible heretofore.

In this embodiment, the function of the band-elimination filter 17 constitutes the invention filter for reducing the out-of-prescribed-band components among the detected distortion components and the band-elimination filter 17 is provided immediately ahead of the auxiliary amplifier 18.

Assuming the band pass loss of the band-elimination filter 17 in the elimination band to be L2 = - 10 dB, out-of-prescribed-band noise can be reduced to about the same numerical value as was indicated in the example explained with regard to the first embodiment.

A feedforward amplifier that is a third embodiment of the present invention will now be explained with reference to the drawings.

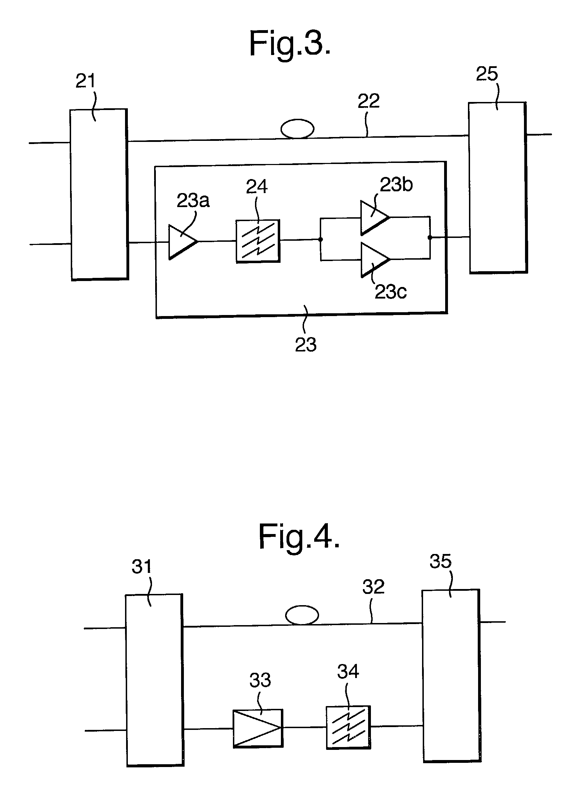

Figure 3 shows part of the configuration of the feedforward amplifier. The illustrated portion includes a second directional coupler 21, a second delay line 22, an auxiliary amplifier 23 composed of multiple amplifiers 23a - 23c, filter 24, and a third directional amplifier 25.

The remainder of the feedforward amplifier is configured after the first embodiment shown in Figure 1. As in the first embodiment, the feedforward amplifier of this third embodiment is also equipped with an input terminal, an output terminal, a first directional coupler, a main amplifier, and a first delay line.

In the feedforward amplifier of this embodiment, the auxiliary amplifier 23 is constituted by combining the amplifiers 23a - 23c, and the filter 24 that reduces out-of-prescribed-band components among the distortion components output from the second directional coupler 21 is incorporated among (intermediate of) the multiple amplifiers 23a - 23c. The filter 24 can be any of various types.

The feedforward amplifier configured in the manner of this third embodiment can, like that of the first embodiment, reduce the out-of-prescribed-band noise contained in the amplified signal output from the output terminal 10.

A feedforward amplifier that is a fourth embodiment of the present invention will now be explained with reference to the drawings.

Figure 4 shows part of the configuration of the feedforward amplifier. The illustrated portion includes a second directional coupler 31, a second delay line 32, an auxiliary amplifier 33, a filter 34, and a third directional amplifier 35.

The remainder of the feedforward amplifier is configured after the first embodiment shown in Figure 1. As in the first embodiment, the feedforward amplifier of this fourth embodiment is also equipped with an input terminal, an output terminal, a first directional coupler, a main amplifier, and a first delay line.

In the feedforward amplifier of this embodiment, the filter 34 that reduces out-of-prescribed-band components among the distortion components output from the second directional coupler 31 is installed behind the auxiliary amplifier 33. The filter 34 can be any of various types.

The feedforward amplifier configured in the manner of this fourth embodiment can, like that of the first embodiment, reduce the out-of-prescribed-band noise contained in the amplified signal output from the output terminal 10.

While the delay lines 4, 6, 14, 16, 22 and 32 are used as the signal delay means in the first to fourth embodiments set out in the foregoing, other means, such as delay filters, can be used instead.

For example, the configuration obtained by replacing the second delay line 6 shown in Figure 1, the second delay line 16 shown in Figure 2, the second delay line 22 shown in Figure 3 or the second delay line 32 shown in Figure 4 with a delay filter enables further reduction of out-of-prescribed-band noise.

An example of the transmission characteristic of a delay filter usable for this purpose is shown in the graph of Figure 5. The horizontal axis of the graph is scaled for frequency and the vertical axis for the level (power) characteristic (transmission characteristic) of a signal passing through the delay filter. The horizontal axis represents frequencies between 800 MHz at the left extremity and 3000 MHz (= 3 GHz) at the right extremity, with each cell representing 220 MHz (= 0.22 GHz). On the vertical axis, each cell represents 20 dB.

The delay filter transmission characteristic shown in Figure 5 enables an approximately 20 dB attenuation of a passed signal in the PHS band relative to the W-CDMA transmit band. This attenuation is expressed here as FL = - 20 dB.

In the case where the delay filter having the transmission characteristic shown by the graph of Figure 5 is installed in the first path (1) of the foregoing first to fourth embodiments, i.e., is provided between the second directional coupler 5 and third directional coupler 9 in Figure 1, between the second directional coupler 15 and the third directional coupler 19 in Figure 2, between the second directional coupler 21 and the third directional amplifier 25 in Figure 3, or between the second directional coupler 31 and the third directional amplifier 35 in Figure 4, and is used to filter the amplified signal from the main amplifier 3 or 13, the power Pno1 of the distortion component noise output from the output terminal 10 or 20 via the first path (1) is represented by Equation 7.

$$Pno1 = (Pnmo + L1) + FL = (- 45)- 20 = - 65 \text{ [dBm]} \qquad \text{(Eq. 7)}$$

From Equation 7 and Equation 5, it follows that the power Pno of the out-of-prescribed-band noise output from the output terminal 10 or 20 of the feedforward amplifier equipped with the delay filter is represented by Equation 7.

$$Pno = Pno1 + Pno2 = - 65 \text{ [dBm]} - 55 \text{ [dBm]} = - 54.6 \text{ [dBm]} \qquad \text{(Eq. 8)}$$

Thus when a filter (delay filter) for reducing the out-of-prescribed-band components contained in the amplified signal output from the second directional coupler 5, 15, 21, 31 to the third directional coupler 9, 19, 25, 35 via the first path (1) is inserted between the second directional coupler 5, 15, 21, 31 and the third directional coupler 9, 19, 25, 35, the out-of-prescribed-band noise contained in the signal output from the output terminal 10, 20 is, assuming the filter to have the transmission characteristic shown in Figure 5, reduced 10 (= - 44.6 - (- 54.6) ) dB relative to the case of the first to fourth embodiments.

The configuration of the feedforward amplifier according to this invention is not limited to that set out in the foregoing and any of various other configurations can be adopted instead. It should also be noted that the present invention can be implemented in the form of a method of executing the processing of the present invention or a program for implementing the method.

In addition, the field of application of the present invention is not limited to that discussed in the foregoing and application in various other fields is also possible.

Further, the various types of processing performed in the feedforward amplifier according to this invention may be constituted by being implemented in hardware resources equipped with a processor and memory and the like, for example, being controlled by means of the processor executing a control program stored in ROM. Further, the various functional means for executing this processing may also be constituted as independent physical circuits.

Moreover, the present invention may also be understood as- the aforesaid program per se or as a floppy disk, CD-ROM or other computer-readable recording media in which the control program is stored, so that the processing according to the present invention can be implemented by loading said control program from the recording medium into a computer and executing the program by a processor.

As explained in the foregoing, the feedforward amplifier of the present invention divides the signal to be amplified, amplifies one divided signal with a main amplifier, combines the amplified signal and the other divided signal to detect distortion components generated in the main amplifier and contained in the amplified signal, amplifies the detected distortion components with an auxiliary amplifier, and combines the amplified distortion components and the amplified signal from the main amplifier to remove those of the distortion components present in a prescribed band from the amplified signal, and in this process the feedforward amplifier reduces out-of-prescribed-band components contained in the detected distortion components with a filter provided ahead of, intermediate of or behind the auxiliary amplifier, thereby improving the characteristics of the out-of-prescribed-band noise contained in the amplified signal from the main amplifier relative to what has been possible with the conventional feedforward amplifier.

**Claims**

1. A feedforward amplifier that divides a signal to be amplified, amplifies one divided signal with a main amplifier, combines the amplified signal and another divided signal to detect distortion components generated in the main amplifier and contained in the amplified signal, amplifies the detected distortion components with an auxiliary amplifier, and combines the amplified distortion components and the amplified signal from the main amplifier to remove those of the distortion components present in a prescribed band from the amplified signal, which feedforward amplifier comprises:

   a filter that reduces out-of-prescribed-band components contained in the detected distortion components.

2. A feedforward amplifier according to claim 1, wherein the filter is provided ahead of the auxiliary amplifier.

3. A feedforward amplifier according to claim 1, wherein the auxiliary amplifier is constituted by combining multiple amplifier elements and the filter is provided intermediate of the multiple amplifier elements constituting the auxiliary amplifier.

4. A feedforward amplifier according to claim 1, wherein the filter is provided behind the auxiliary amplifier.

5. A feedforward amplifier according to any of claims 1 to 4, further comprising a filter that reduces the out-of-prescribed-band components contained in the amplified signal from the main amplifier combined with the amplified distortion components.

6. A feedforward amplifier according to claim 1, which comprises:

   a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and
   a distortion removal loop including second delay means that delays the amplified signal from the main amplifier, an auxiliary amplifier that amplifies the distortion components detected by the second directional coupler, a third directional coupler that combines amplified distortion components from the auxiliary amplifier and the amplified signal delayed by the second delay means to remove those of the distortion components present in a prescribed band from the amplified signal, and a filter that reduces out-of-prescribed-band components contained in the distortion components detected by the second directional coupler.

7. A feedforward amplifier according to claim 2, which comprises:

   a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and
   a distortion removal loop including second delay means that delays the amplified signal from the main amplifier, a filter that reduces out-of-prescribed-band components contained in the distortion components detected by the second directional coupler, an auxiliary amplifier that amplifies the distortion components from the filter, and a third directional coupler that combines amplified distortion components from the auxiliary amplifier and the amplified signal delayed by the second delay means to remove those of the distortion components present in a prescribed band from the amplified signal.

**8.** A feedforward amplifier according to claim 3, which comprises:

a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and
a distortion removal loop including second delay means that delays the amplified signal from the main amplifier, an auxiliary amplifier constituted by combining multiple amplifier elements that amplifies the distortion components detected by the second directional coupler, a filter provided intermediate of the multiple amplifier elements constituting the auxiliary amplifier that reduces out-of-prescribed-band components contained in the distortion components detected by the second directional coupler, and a third directional coupler that combines amplified distortion components from the auxiliary amplifier and the amplified signal delayed by the second delay means to remove those of the distortion components present in a prescribed band from the amplified signal.

**9.** A feedforward amplifier according to claim 4, which comprises:

a distortion detection loop including a first directional coupler that divides the signal to be amplified, a main amplifier that amplifies one divided signal, first delay means that delays another divided signal, and a second directional coupler that combines an amplified signal from the main amplifier and the other divided signal delayed by the first delay means to detect distortion components generated in the main amplifier and contained in the amplified signal; and
a distortion removal loop including second delay means that delays the amplified signal from the main amplifier, an auxiliary amplifier that amplifies the distortion components detected by the second directional coupler, a filter that reduces out-of-prescribed-band components contained in the amplified distortion components from the auxiliary amplifier, and a third directional coupler that combines amplified distortion components from the filter and the amplified signal delayed by the second delay means to remove those of the distortion components present in a prescribed band from the amplified signal.

**10.** A feedforward amplifier according to any of claims 6 to 9, wherein the second delay means is a filter that reduces the out-of-prescribed-band components contained in the amplified signal from the main amplifier.

# Fig.1.

# Fig.2.

# Fig.3.

# Fig.4.

## Fig.5.

CH1

PRm

Oor

521  100MAG  20 00/ REF -1.017dB 1: -0.3851dB
2 009.780 000MHz
3: -1.0168dB
3: -40.707dB
1.670GHz

PHS band
attenuation of
approx. 20dB

Level

Transmit band

Start 800.000 000MHz        Stop 3000.000 000MHz

Frequency ⟶

## Fig.6.